# EUROPEAN PATENT APPLICATION

(11) **EP 4 567 143 A1**
(43) Date of publication of application: **11.06.2025**
(21) Application number: 23849991.7
(22) Date of filing: 27.07.2023
(51) Int. Cl.: C22C 28/00, C22C 30/00, C22C 30/02, C22C 30/04, C22C 30/06, H01L 23/373, C22F 1/16, B23K 35/26, H05K 1/09

(54) **METAL AND ELECTRONIC DEVICE**

(30) Priority: 01.08.2022 JP 2022122466; 15.11.2022 JP 2022182319
(71) Applicant: Senju Metal Industry Co., Ltd., Tokyo 120-8555 (JP)
(72) Inventor: AKATSUKA, Shuta, Tokyo 120-8555 (JP); HASHIMOTO, Yutaka, Tokyo 120-8555 (JP); OTA, Kengo, Tokyo 120-8555 (JP); OKADA, Sakie, Tokyo 120-8555 (JP)
(74) Representative: Hoffmann Eitle
(86) International application number: PCT/JP2023/027494
(87) International publication number: WO 2024/029436

(57) **Abstract**

A metal according to the present invention comprises Ga and Bi, wherein the metal includes a liquid metal or a liquid metal and a solid metal at 35°C. The metal according to the present invention may comprise Bi in an amount of 0.01 mass% or more and 30 mass% or less. The metal according to the present invention may further comprise any one or more of In, Sn, Zn, and Ag.

## Description

### [TECHNICAL FIELD]

The present invention relates to a metal and an electronic device using the metal.

### [BACKGROUND ART]

An attempt has conventionally been made to provide a liquid metal, for example JP 2019-516208 A proposes to provide a conducting shear thinning gel composition, which includes a eutectic gallium alloy and gallium oxide sheets distributed as microstructures within the gallium alloy, and in which a mixture of the eutectic gallium alloy and gallium oxide has about 59.9% to about 99.9% of the eutectic gallium alloy in weight percent (wt%) and about 0.1% to about 2.0% of gallium oxide in wt%.

### [SUMMARY OF INVENTION]

### [PROBLEM TO BE SOLVED BY INVENTION]

A metal including a liquid metal containing Ga as disclosed in JP 2019-516208 A has a problem that the shape changes and the heat dissipation decreases due to the growth of an oxide while generating hydrogen on the basis of the property that Ga is easily oxidized. In particular, Ga has a strong tendency to be selectively oxidized under high temperature and high humidity.

The present invention provides a metal which contains Ga and is hardly oxidized while including a liquid metal, and an electronic device using the metal.

### [MEANS FOR SOLVING PROBLEM]

### [Concept 1]

A metal according to the present invention may comprise Ga and Bi,
wherein the metal may include a liquid metal or a liquid metal and a solid metal at 35°C.

### [Concept 2]

The metal according to concept 1 may comprise Bi in an amount of 0.01 mass% or more and 30 mass% or less.

### [Concept 3]

The metal according to concept 1 or 2 may further comprise any one or more of In, Sn, Zn, and Ag.

### [Concept 4]

The metal according to any one of concepts 1 to 3 may further comprise any one or more of Ag, Sb, Cu, Fe, Al, As, Ni, Au, Ti, Cr, La, Mg, Mn, Co, Ge, Cd, Pb, P, S, and Si.

### [Concept 5]

The metal according to any one of concepts 1 to 4 may comprise Ga in an amount of 30 mass% or more and 99.99 mass% or less, and Bi in an amount of 0.01 mass% or more and 30 mass% or less.

### [Concept 6]

In the metal according to any one of concepts 1 to 5,
a remainder other than Ga and Bi may be any one or more of In, Sn, Zn, and Ag.

### [Concept 7]

In the metal according to any one of concepts 1 to 5,
a remainder other than Ga and Bi may be any one or more of In, Sn, Zn, and Ag, and any one or more of In, Sn, Zn, and Ag, and any one or more of Sb, Cu, Fe, Al, As, Ni, Au, Ti, Cr, La, Mg, Mn, Co, Ge, Cd, Pb, P, S, and Si.

### [Concept 8]

The metal according to any one of concepts 1 to 7 may be used as a heat dissipation material.

### [Concept 9]

An electronic device according to the present invention may use the metal according to any one of concepts 1 to 7 as a heat dissipation material.

### [BRIEF DESCRIPTION OF FIGURES]

Fig. 1A is a photograph of 24.5In-GaBal containing no Bi and ranked F after being treated in an environment of 85°C and 85% RH for 48 hours.
Fig. 1B is a photograph of 24.5In-GaBal containing 1.5% of Bi and ranked A after being treated in an environment of 85°C and 85% RH for 48 hours.
Fig. 2 is a through-hole substrate which is a test substrate used in examples.
Fig. 3A is a photograph of a test substrate filled with a metal of the present embodiment as viewed from the front.
Fig. 3B is an enlarged photograph of the test substrate filled with a metal of the present embodiment as viewed from the front.
Fig. 3C is a photograph of the test substrate filled with a metal of the present embodiment as viewed from the back.
Fig. 4 illustrates an example of an image obtained by measurement.

### [EMBODIMENT OF THE INVENTION]

A metal of the present embodiment contains Ga and Bi, and may be a liquid metal at 35°C, or may be in an aspect including a liquid metal and a solid metal at 35°C. Each or one of the liquid metal and the solid metal may be an alloy. The composition of the alloy in the liquid metal and the composition of the alloy in the solid metal may be different. However, the present invention is not limited to such an aspect, and the composition of the alloy in the liquid metal and the composition of the alloy in the solid metal may have the same composition. The metal of the present embodiment may be a Ga-based metal. The metal of the present embodiment preferably includes a liquid metal or a liquid metal and a solid metal at 30°C. Since Ga has a melting point of about 30°C, a metal including a liquid metal or a mixture of a liquid metal and a solid metal can be provided by using Ga as a base material. Ga may be contained in an amount of 30 mass% or more and less than 100 mass%. Ga is a metal having a high heat dissipation effect, and further, a metal can be transformed into a liquid state by incorporating Ga, and therefore the lower limit value thereof is preferably 30 mass%, more preferably 40 mass%, and still more preferably 50 mass%.

The metal may contain Bi in an amount of 0.01 mass% or more and 30 mass% or less with respect to the entire metal (when the metal is formed of a liquid metal, the entire liquid metal and when the metal is a mixture of a liquid metal and a solid metal, the entire mixture). The lower limit value of Bi is preferably 0.03 mass%, more preferably 0.05 mass%, and still more preferably 0.1 mass%. When the content of Bi is too large, heat dissipation is deteriorated, and thus the upper limit value is preferably set to 30 mass%, more preferably set to 20 mass%, still more preferably set to 15 mass%, and even more preferably set to 10 mass%.

The metal of the present embodiment is typically used as a heat dissipation material such as a thermal grease. In the present embodiment, an electronic device using such a metal is also provided. As an example, in an electronic device of the present embodiment, an electronic component is placed on a circuit board via a thermal grease formed of a liquid metal or a liquid metal and a solid metal. The metal of the present embodiment may be printed on a circuit board such as a printed wiring board using a squeegee, or may be printed using an inkjet printer, or may be applied using a dispensing device.

The metal of the present embodiment may contain only Ga and Bi, or may further contain any one or more of In, Sn, Zn, and Ag in addition to Ga and Bi. In this case, the metal may be formed of Ga, Bi, and inevitable impurities, or may be formed of inevitable impurities and Ga other than Bi and any one or more metals of In, Sn, Zn, and Ag. The inevitable impurities in the present application mean impurities that are not intentionally added. The metal of the present embodiment may be a eutectic metal alloy, but need not be a eutectic metal alloy.

The inventors of the present application conducted intensive studies on the problem of an oxide of Ga in a metal including a liquid metal, and found that the oxidation of Ga can be prevented by incorporating Bi. Although it is merely a presumption, the mechanism by which the oxidation of Ga can be prevented by using Bi is considered as follows.

Bi is an element classified as an acidic oxide, and has a property of reacting with water to generate an acid. Therefore, an acid is generated by incorporating Bi, and the generated acid reacts with Ga to generate a hydroxide on the surface of the alloy. It is considered that when such a hydroxide is generated on the surface of the alloy, the reaction between Ga and water can be prevented, and the generation of an oxide of Bi is prevented.

The content of metals other than Ga and Bi may be 70 mass% or less, 60 mass% or less, 50 mass% or less, 40 mass% or less, 30 mass% or less, or 20 mass% or less.

As an example, it may be formed of a quinary alloy such as Ga-In-Sn-Zn-Bi, a quaternary alloy such as Ga-In-Sn-Bi or Ga-Sn-Zn-Bi, a ternary alloy such as Ga-In-Bi, or a binary alloy of Ga-Bi.

Examples thereof include metals having a composition as follows. When the metal is formed of a liquid metal, the mass% with respect to the entire liquid metal is shown below, and when the metal is formed of a mixture of a liquid metal and a solid metal, the mass% with respect to the entire mixture is shown below.

A metal that includes a liquid metal or a liquid metal and a solid metal at 35°C, and is formed of 2 to 35 mass% of In, 0.01 to 30 mass% of Bi, and the balance including Ga.

A metal that includes a liquid metal or a liquid metal and a solid metal at 35°C, and is formed of 2 to 30 mass% of Sn, 0.01 to 30 mass% of Bi, and the balance including Ga.

A metal that includes a liquid metal or a liquid metal and a solid metal at 35°C, and is formed of 2 to 30 mass% of Sn, 0.3 to 10 mass% of Zn, 0.01 to 30 mass% of Bi, and the balance including Ga.

A metal that includes a liquid metal or a liquid metal and a solid metal at 35°C, and is formed of 2 to 40 mass% of In, 2 to 30 mass% of Sn, 0.01 to 30 mass% of Bi, and the balance including Ga. In this composition, the upper limit of In is 20 mass%, and the metal may be a metal that includes a liquid metal or a liquid metal and a solid metal at 35°C, and is formed of 2 to 20 mass% of In, 2 to 30 mass% of Sn, 0.01 to 30 mass% of Bi, and the balance including Ga.

A metal that includes a liquid metal or a liquid metal and a solid metal at 35°C, and is formed of 1 to 10 mass% of Zn, 0.01 to 30 mass% of Bi, and the balance including Ga.

A metal that includes a liquid metal or a liquid metal and a solid metal at 35°C, and is formed of 1 to 10 mass% of Ag, 0.01 to 30 mass% of Bi, and the balance including Ga.

A metal that includes a liquid metal or a liquid metal and a solid metal at 35°C, and is formed of 1 to 35 mass% of In, 5 to 20 mass% of Sn, 0.1 to 5 mass% of Zn, 0.01 to 30 mass% of Bi, and the balance including Ga.

As examined by the inventors, the amount of Bi contained in the liquid metal is limited. Therefore, considering only the fact that Bi is contained as a liquid and the heat dissipation effect is excellent, the upper limit of the content of Bi is preferably 1.5 mass%, more preferably 1.0 mass%, and still more preferably 0.8 mass% (in particular, in an aspect in which In and Sn or In, Sn and Zn are contained among the aspects shown in the above examples). In addition, if emphasis is placed only on the fact that Bi exists as a liquid more reliably, an aspect in which the upper limit value is 0.4 mass% may be adopted.

Also in these aspects, the balance may include inevitable impurities.

However, the present invention is not limited to such an aspect, and for example, any one or more of Ag, Sb, Cu, Fe, Al, As, Ni, Au, Ti, Cr, La, Mg, Mn, Co, Ge, Cd, Pb, P, S, and Si may be contained in addition to Ga and Bi and any one or two or more of In, Sn, and Zn. In addition, any one or more of Ag, Sb, Cu, Fe, Al, As, Ni, Au, Ti, Cr, La, Mg, Mn, Co, Ge, Cd, Pb, P, S, and Si may be contained in addition to Ga and Bi without containing In, Sn, and Zn. The balance may include Ga and inevitable impurities. Even in the aspect described in the closed claim in the present application, inevitable impurities are included. The inevitable impurities mean impurities that are not intentionally contained.

Examples thereof include metals as follows. Also here, when the metal is formed of a liquid metal, the mass% with respect to the entire liquid metal is shown below, and when the metal is formed of a mixture of a liquid metal and a solid metal, the mass% with respect to the entire mixture is shown below.

A metal that includes a liquid metal or a liquid metal and a solid metal at 35°C, and is formed of 5 to 20 mass% of Sn, 0.1 to 5 mass% of Zn, 0.01 to 30 mass% of Bi, 0.01 to 1 mass% of any one or more of Ag, Sb, Cu, Fe, Al, As, Ni, Au, Ti, Cr, La, Mg, and Mn, and the balance including Ga.

A metal that includes a liquid metal or a liquid metal and a solid metal at 35°C, and is formed of 2 to 35 mass% of In, 0.01 to 30 mass% of Bi, 0.01 to 1 mass% of any one or more of Ag, Sb, Cu, Fe, Al, As, Ni, Au, Ti, Cr, La, Mg, and Mn, and the balance including Ga.

Also in these aspects, the balance may include inevitable impurities.

A heat dissipation material containing the metal of the present embodiment may further contain an amine, a resin, a solvent, or the like. In this case, 10 to 90 mass% of the metal (a liquid metal or a mixture of a liquid metal and a solid metal) according to the present embodiment, 10 to 90 mass% of an amine, 10 to 90 mass% of a resin, and 10 to 90 mass% of a solvent may be contained to make the total 100 mass%. In addition, an aspect in which the balance includes an activator or an activator and a solvent with respect to 10 to 90 mass% of the metal may be adopted.

Examples of the amine include linear, branched, and/or cyclic saturated or unsaturated aliphatic amines, aromatic amines, and imidazoles. Examples of the aliphatic amines include methylamine, ethylamine, dimethylamine, 1-aminopropane, isopropylamine, trimethylamine, n-ethylmethylamine, allylamine, n-butylamine, diethylamine, sec-butylamine, tert-butylamine, N,N-dimethylethylamine, isobutylamine, pyrrolidine, 3-pyrroline, n-pentylamine, dimethylaminopropane, 1-aminohexane, triethylamine, diisopropylamine, dipropylamine, hexamethyleneimine, 1-methylpiperidine, 2-methylpiperidine, 4-methylpiperidine, cyclohexylamine, diallylamine, n-octylamine, aminomethyl, cyclohexane, 2-ethylhexylamine, dibutylamine, diisobutylamine, 1,1,3,3-tetramethylbutylamine, 1-cyclohexylethylamine, and N,N-dimethylcyclohexylamine. Examples of the aromatic amines include aniline, diethylaniline, pyridine, diphenylguanidine, and ditolylguanidine. Examples of the imidazoles include imidazole, 2-methylimidazole, 2-ethyl-4-methylimidazole, 2-phenylimidazole, 2-phenyl-4-methylimidazole, and 1-benzyl-2-phenylimidazole.

Examples of the resin include an epoxy resin, a rosin-based resin, a (meth)acrylic resin, a urethane-based resin, a polyester-based resin, a phenoxy resin, a vinyl ether-based resin, a terpene resin, a modified terpene resin (such as an aromatic modified terpene resin, a hydrogenated terpene resin, or a hydrogenated aromatic modified terpene resin), a terpene-phenol resin, a modified terpene-phenol resin (such as a hydrogenated terpene-phenol resin), a styrene resin, a modified styrene resin (such as a styrene-acrylic resin or a styrene-maleic resin), a xylene resin, and a modified xylene resin (such as a phenol-modified xylene resin, an alkylphenol-modified xylene resin, a phenol-modified resol-type xylene resin, a polyol-modified xylene resin, or a polyoxyethylene-added xylene resin).

Examples of the solvent include an alcohol-based solvent, a glycol ether-based solvent, a terpineol, a hydrocarbon, an ester, and water.

### [Examples]

Hereinafter, the present embodiment will be described in detail with reference to examples and comparative examples. The present embodiment is not limited to these examples.

### [Test method]

### 1. Method for preparing test metal

In a beaker, predetermined amounts of additive elements (elements shown in each table other than Bi) were weighed and added to Ga which was transformed into a liquid state by heating to 40°C in advance (the input amounts are amounts shown in each table described later) and the mixture was heated on a hot plate at 250°C for 1 hour to prepare a mother alloy.

The mother alloy was weighed in a beaker, a predetermined amount of Bi was added (the input amount is an amount shown in each table described later), and the mixture was heated on a hot plate at 250°C for 1 hour, and cooled to room temperature to prepare a test sample.

### 2. Method for preparing test piece

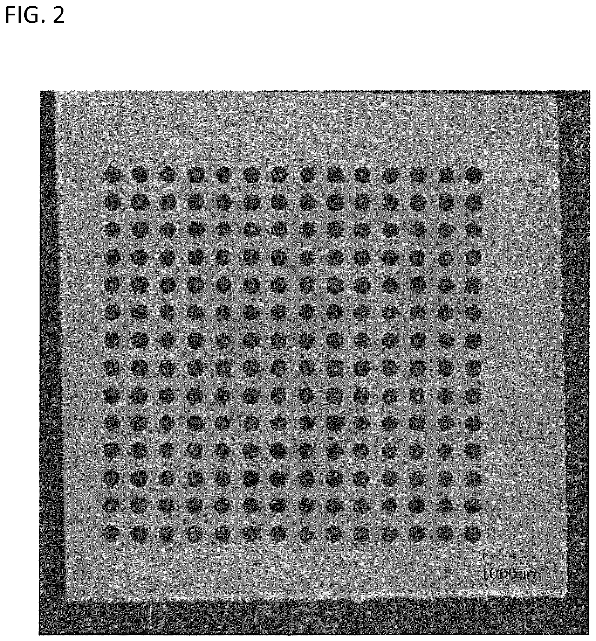

A through-hole substrate shown in Fig. 2 was filled with a metal to prepare a test piece.

A test substrate formed of a through-hole substrate is as follows.
· Material: FR4 (copper foil, no resist)
· Thickness: 0.50 mm
· Hole diameter: Φ 0.525 mm
· Number of holes: 14 × 14 = 196
· Hole pitch: 0.90 mm

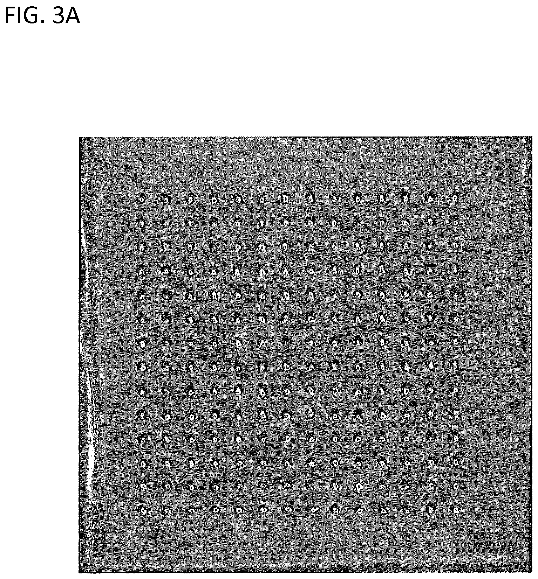

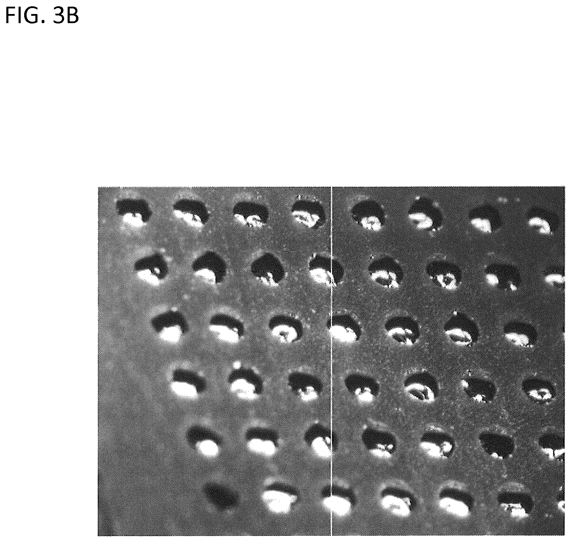

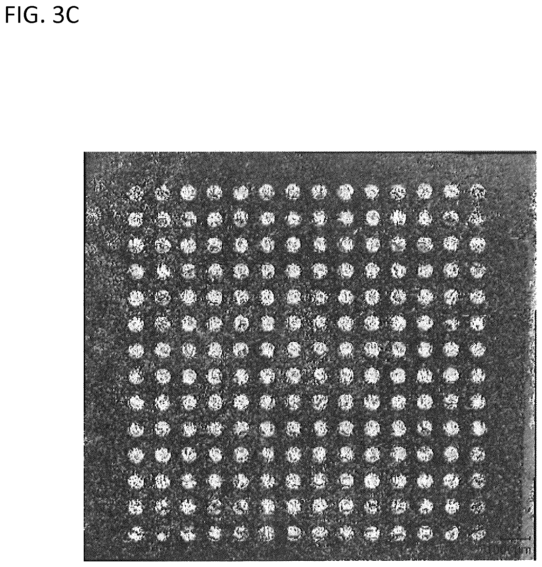

(1) The through-hole of the test substrate was filled with the test sample.
(2) The excess metal on the front and back surfaces was wiped off with IPA.
(3) The back surface was sealed with Kapton tape to prepare a test piece.
(4) The prepared test piece was treated in an environment of 85°C and 85% RH (relative humidity) for 48 hours, and the growth state of an oxide was measured. Figs. 3A and 3B are photographs of the test substrate filled with the metal as viewed from the front, and Fig. 3C is a photograph of the test substrate filled with the metal as viewed from the back.

### 3. Determination method

The maximum height of the oxide from the substrate surface in each hole was measured. As a measuring machine, a VK-X1000 laser microscope manufactured by KEYENCE CORPORATION was used.

The determination criteria are as follows.

### Maximum height of oxide

Rank A: less than 250 µm
Rank B: 250 µm or more and less than 500 µm
Rank C: 500 µm or more and less than 750 µm
Rank D: 750 µm or more and less than 1,000 µm
Rank E: 1,000 µm or more and less than 1,500 µm
Rank F: 1,500 µm or more and less than 1,750 µm
Rank G: 2,000 µm or more

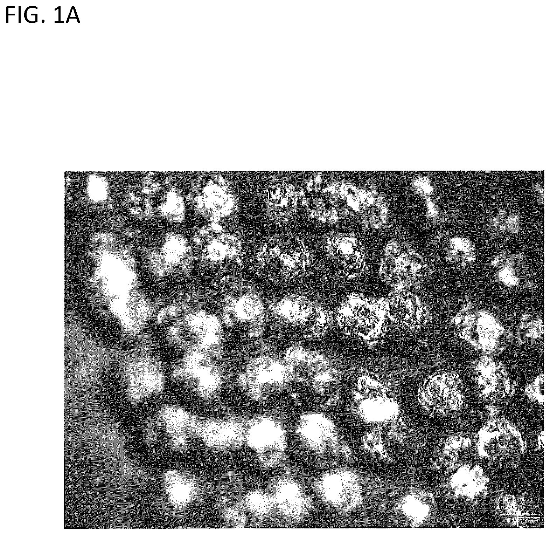

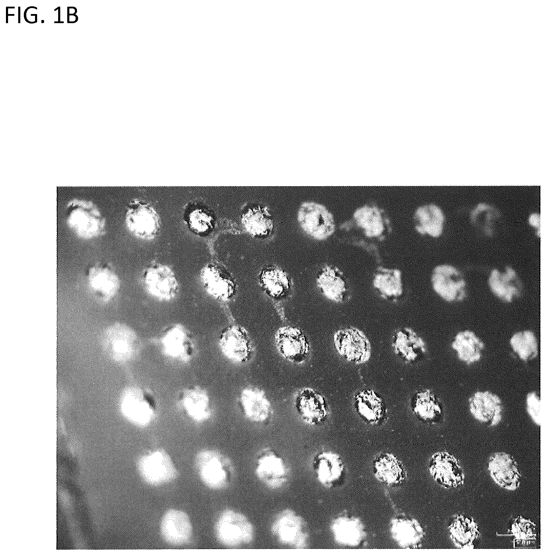

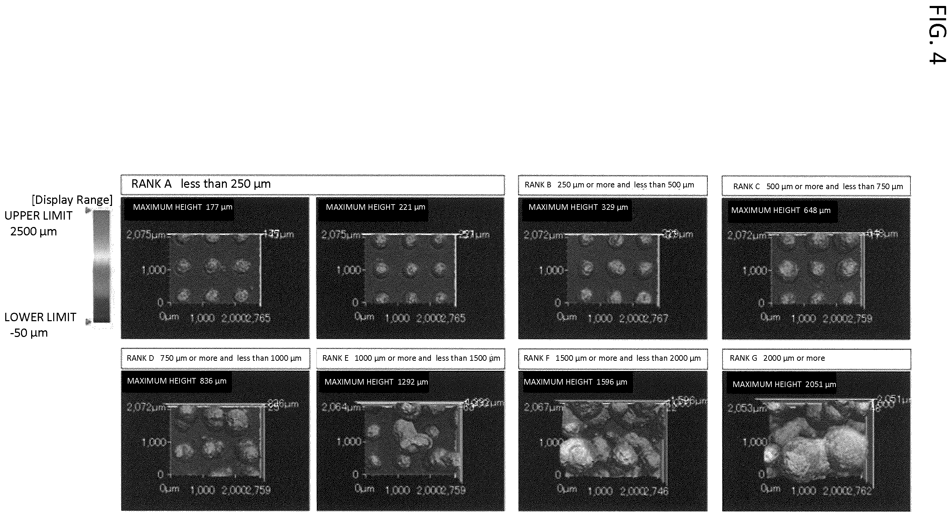

Fig. 1A is a photograph of 24.5In-GaBal containing no Bi and ranked F after being treated in an environment of 85°C and 85% RH for 48 hours, and Fig. 1B is a photograph of 24.5In-GaBal containing 1.5 mass% of Bi and ranked A after being treated in an environment of 85°C and 85% RH for 48 hours. Fig. 4 illustrates an image obtained by measurement as an example.

The results of examples and comparative examples are shown in the following tables. The balance is denoted as "Bal" in each table below and the present description. Further, in each table, when the alloy is formed of a liquid metal, the mass% with respect to the entire liquid metal is shown, and when the alloy is formed of a mixture of a liquid metal and a solid metal, the mass% with respect to the entire mixture is shown.

As can be understood from the experimental results shown in the following tables, the growth of an oxide could be effectively prevented by incorporating Bi in each composition. In addition, the growth of an oxide could be effectively prevented by increasing the content of Bi.

More specifically, Tables 1 and 2 show the results for alloys containing In in addition to Ga and Bi. The growth of an oxide could be effectively prevented by incorporating Bi. In addition, the effect can be further enhanced by increasing the content of Bi.

**[Table 1]**

| Ga-In | Ga | In | Bi | Maximum height (µm) | Rank |
|---|---|---|---|---|---|
| Comparative Example 1 | Bal | 33.00 | 0.00 | 1658 | F |
| Example 1 | Bal | 33.00 | 0.05 | 953 | D |
| Example 2 | Bal | 33.00 | 0.15 | 524 | C |
| Example 3 | Bal | 33.00 | 0.50 | 198 | A |
| Comparative Example 2 | Bal | 24.50 | 0.00 | 1596 | F |
| Example 4 | Bal | 24.50 | 0.01 | 1105 | E |
| Example 5 | Bal | 24.50 | 0.03 | 1089 | E |
| Example 6 | Bal | 24.50 | 0.05 | 775 | D |
| Example 7 | Bal | 24.50 | 0.15 | 648 | C |
| Example 8 | Bal | 24.50 | 0.30 | 231 | A |
| Example 9 | Bal | 24.50 | 0.50 | 207 | A |
| Example 10 | Bal | 24.50 | 0.80 | 177 | A |
| Example 11 | Bal | 24.50 | 1.00 | 161 | A |
| Example 12 | Bal | 24.50 | 1.50 | 152 | A |
| Example 13 | Bal | 24.50 | 2.00 | 149 | A |
| Example 14 | Bal | 24.50 | 2.50 | 128 | A |
| Example 15 | Bal | 24.50 | 20.00 | 97 | A |

**[Table 2]**

| Ga-In | Ga | In | Bi | Maximum height (µm) | Rank |
|---|---|---|---|---|---|
| Comparative Example 3 | Bal | 11.00 | 0.00 | 2105 | G |
| Example 16 | Bal | 11.00 | 0.05 | 852 | D |
| Example 17 | Bal | 11.00 | 0.15 | 514 | C |
| Example 18 | Bal | 11.00 | 0.50 | 214 | A |
| Comparative Example 4 | Bal | 5.00 | 0.00 | 2051 | G |
| Example 19 | Bal | 5.00 | 0.03 | 1490 | E |
| Example 20 | Bal | 5.00 | 0.05 | 1427 | E |
| Example 21 | Bal | 5.00 | 0.15 | 1357 | E |
| Example 22 | Bal | 5.00 | 0.30 | 836 | D |
| Example 23 | Bal | 5.00 | 0.50 | 608 | C |
| Example 24 | Bal | 5.00 | 0.80 | 264 | B |
| Example 25 | Bal | 5.00 | 1.00 | 189 | A |
| Example 26 | Bal | 5.00 | 1.50 | 125 | A |
| Example 27 | Bal | 5.00 | 2.00 | 120 | A |
| Example 28 | Bal | 5.00 | 2.50 | 117 | A |
| Example 29 | Bal | 5.00 | 20.00 | 94 | A |

Table 3 shows the results for alloys containing Sn in addition to Ga and Bi. The growth of an oxide could be effectively prevented by incorporating Bi. In addition, the effect can be further enhanced by increasing the content of Bi.

**[Table 3]**

| Ga-Sn | Ga | Sn | Bi | Maximum height (µm) | Rank |
|---|---|---|---|---|---|
| Example 30 | Bal | 20.00 | 0.05 | 598 | C |
| Example 31 | Bal | 20.00 | 0.15 | 487 | B |
| Example 32 | Bal | 20.00 | 0.50 | 342 | B |

| Comparative Example 5 | Bal | 11.00 | 0.00 | 1553 | F |
|---|---|---|---|---|---|
| Example 33 | Bal | 11.00 | 0.01 | 848 | D |
| Example 34 | Bal | 11.00 | 0.03 | 833 | D |
| Example 35 | Bal | 11.00 | 0.05 | 623 | C |
| Example 36 | Bal | 11.00 | 0.15 | 557 | C |
| Example 37 | Bal | 11.00 | 0.30 | 421 | B |
| Example 38 | Bal | 11.00 | 0.50 | 403 | B |
| Example 39 | Bal | 11.00 | 0.80 | 333 | B |
| Example 40 | Bal | 11.00 | 1.00 | 287 | B |
| Example 41 | Bal | 11.00 | 1.50 | 209 | A |
| Example 42 | Bal | 11.00 | 2.00 | 156 | A |
| Example 43 | Bal | 11.00 | 2.50 | 134 | A |
| Example 44 | Bal | 11.00 | 20.00 | 108 | A |
| Comparative Example 6 | Bal | 5.00 | 0.00 | 1521 | F |
| Example 45 | Bal | 5.00 | 0.05 | 983 | D |
| Example 46 | Bal | 5.00 | 0.15 | 772 | D |
| Example 47 | Bal | 5.00 | 0.50 | 449 | B |

Tables 4 and 5 show the results for alloys containing Sn and Zn in addition to Ga and Bi. The growth of an oxide could be effectively prevented by incorporating Bi. In addition, the effect can be further enhanced by increasing the content of Bi.

**[Table 4]**

| Ga-Sn-Zn | Ga | Sn | Zn | Bi | Maximum height (µm) | Rank |
|---|---|---|---|---|---|---|
| Comparative Example 7 | Bal | 22.00 | 5.00 | 0.00 | 1548 | F |
| Example 48 | Bal | 22.00 | 5.00 | 0.05 | 1106 | E |
| Example 49 | Bal | 22.00 | 5.00 | 0.15 | 778 | D |
| Example 50 | Bal | 22.00 | 5.00 | 0.50 | 521 | C |
| Comparative Example 8 | Bal | 22.00 | 0.50 | 0.00 | 1601 | F |
| Example 51 | Bal | 22.00 | 0.50 | 0.05 | 1257 | E |
| Example 52 | Bal | 22.00 | 0.50 | 0.15 | 804 | D |
| Example 53 | Bal | 22.00 | 0.50 | 0.50 | 586 | C |
| Comparative Example 9 | Bal | 11.00 | 3.00 | 0.00 | 1623 | F |
| Example 54 | Bal | 11.00 | 3.00 | 0.01 | 1452 | E |
| Example 55 | Bal | 11.00 | 3.00 | 0.03 | 1320 | E |
| Example 56 | Bal | 11.00 | 3.00 | 0.05 | 1261 | E |
| Example 57 | Bal | 11.00 | 3.00 | 0.15 | 917 | D |
| Example 58 | Bal | 11.00 | 3.00 | 0.30 | 664 | C |
| Example 59 | Bal | 11.00 | 3.00 | 0.50 | 551 | C |
| Example 60 | Bal | 11.00 | 3.00 | 0.80 | 236 | A |
| Example 61 | Bal | 11.00 | 3.00 | 1.00 | 142 | A |
| Example 62 | Bal | 11.00 | 3.00 | 1.50 | 167 | A |
| Example 63 | Bal | 11.00 | 3.00 | 2.00 | 122 | A |
| Example 64 | Bal | 11.00 | 3.00 | 2.50 | 146 | A |
| Example 65 | Bal | 11.00 | 3.00 | 20.00 | 112 | A |

**[Table 5]**

| Ga-Sn-Zn | Ga | Sn | Zn | Bi | Maximum height (µm) | Rank |
|---|---|---|---|---|---|---|
| Comparative Example 10 | Bal | 5.00 | 5.00 | 0.00 | 1655 | F |
| Example 66 | Bal | 5.00 | 5.00 | 0.05 | 1381 | E |
| Example 67 | Bal | 5.00 | 5.00 | 0.15 | 946 | D |
| Example 68 | Bal | 5.00 | 5.00 | 0.50 | 745 | C |
| Comparative Example 11 | Bal | 5.00 | 0.50 | 0.00 | 1668 | F |
| Example 69 | Bal | 5.00 | 0.50 | 0.05 | 1394 | E |
| Example 70 | Bal | 5.00 | 0.50 | 0.15 | 983 | D |
| Example 71 | Bal | 5.00 | 0.50 | 0.50 | 768 | D |

Tables 6 and 7 show the results for alloys containing Sn and In in addition to Ga and Bi. The growth of an oxide could be effectively prevented by incorporating Bi. In addition, the effect can be further enhanced by increasing the content of Bi.

**[Table 6]**

| Ga-In-Sn | Ga | In | Sn | Bi | Maximum height (µm) | Rank |
|---|---|---|---|---|---|---|
| Comparative Example 12 | Bal | 31.00 | 22.00 | 0.00 | 1594 | F |
| Example 72 | Bal | 31.00 | 22.00 | 0.05 | 1421 | E |
| Example 73 | Bal | 31.00 | 22.00 | 0.15 | 1109 | E |
| Example 74 | Bal | 31.00 | 22.00 | 0.50 | 467 | B |
| Comparative Example 13 | Bal | 35.00 | 5.00 | 0.00 | 1603 | F |
| Example 75 | Bal | 35.00 | 5.00 | 0.05 | 1437 | E |
| Example 76 | Bal | 35.00 | 5.00 | 0.15 | 1154 | E |
| Example 77 | Bal | 35.00 | 5.00 | 0.50 | 499 | B |
| Comparative Example 14 | Bal | 20.00 | 14.00 | 0.00 | 2348 | G |
| Example 78 | Bal | 20.00 | 14.00 | 0.05 | 1491 | E |
| Example 79 | Bal | 20.00 | 14.00 | 0.15 | 1175 | E |
| Example 80 | Bal | 20.00 | 14.00 | 0.30 | 815 | D |
| Example 81 | Bal | 20.00 | 14.00 | 0.50 | 529 | C |
| Example 82 | Bal | 20.00 | 14.00 | 0.80 | 484 | B |
| Example 83 | Bal | 20.00 | 14.00 | 1.00 | 241 | A |
| Example 84 | Bal | 20.00 | 14.00 | 1.50 | 220 | A |
| Example 85 | Bal | 20.00 | 14.00 | 2.00 | 237 | A |
| Example 86 | Bal | 20.00 | 14.00 | 2.50 | 221 | A |
| Example 87 | Bal | 20.00 | 14.00 | 20.00 | 134 | A |

**[Table 7]**

| Ga-In-Sn | Ga | In | Sn | Bi | Maximum height (µm) | Rank |
|---|---|---|---|---|---|---|
| Comparative Example 15 | Bal | 5.00 | 20.00 | 0.00 | 1624 | F |
| Example 88 | Bal | 5.00 | 20.00 | 0.05 | 1497 | E |
| Example 89 | Bal | 5.00 | 20.00 | 0.15 | 1201 | E |
| Example 90 | Bal | 5.00 | 20.00 | 0.50 | 568 | C |
| Comparative Example 16 | Bal | 5.00 | 5.00 | 0.00 | 1687 | F |
| Example 91 | Bal | 5.00 | 5.00 | 0.05 | 1369 | E |
| Example 92 | Bal | 5.00 | 5.00 | 0.15 | 1237 | E |
| Example 93 | Bal | 5.00 | 5.00 | 0.50 | 587 | C |

Table 8 shows the results for alloys containing Zn in addition to Ga and Bi. The growth of an oxide could be effectively prevented by incorporating Bi. In addition, the effect can be further enhanced by increasing the content of Bi.

**[Table 8]**

| Ga-Zn | Ga | Zn | Bi | Maximum height (µm) | Rank |
|---|---|---|---|---|---|
| Example 94 | Bal | 7.50 | 0.05 | 1224 | E |
| Example 95 | Bal | 7.50 | 0.15 | 968 | D |
| Example 96 | Bal | 7.50 | 0.50 | 754 | D |
| Comparative Example 17 | Bal | 5.00 | 0.00 | 1542 | F |
| Example 97 | Bal | 5.00 | 0.01 | 1268 | E |
| Example 98 | Bal | 5.00 | 0.03 | 1241 | E |
| Example 99 | Bal | 5.00 | 0.05 | 1168 | E |
| Example 100 | Bal | 5.00 | 0.15 | 996 | D |
| Example 101 | Bal | 5.00 | 0.30 | 848 | D |
| Example 102 | Bal | 5.00 | 0.50 | 784 | D |
| Example 103 | Bal | 5.00 | 0.80 | 712 | C |
| Example 104 | Bal | 5.00 | 1.00 | 668 | C |
| Example 105 | Bal | 5.00 | 1.50 | 613 | C |
| Example 106 | Bal | 5.00 | 2.00 | 517 | C |
| Example 107 | Bal | 5.00 | 2.50 | 465 | B |
| Example 108 | Bal | 5.00 | 20.00 | 431 | B |
| Comparative Example 18 | Bal | 3.00 | 0.00 | 1556 | F |
| Example 109 | Bal | 3.00 | 0.05 | 1284 | E |
| Example 110 | Bal | 3.00 | 0.15 | 1024 | E |
| Example 111 | Bal | 3.00 | 0.50 | 792 | D |

Table 9 shows the results for alloys containing Ag in addition to Ga and Bi. The growth of an oxide could be effectively prevented by incorporating Bi. In addition, the effect can be further enhanced by increasing the content of Bi.

**[Table 9]**

| Ga-Ag | Ga | Ag | Bi | Maximum height (µm) | Rank |
|---|---|---|---|---|---|
| Example 112 | Bal | 5.00 | 0.05 | 1237 | E |
| Example 113 | Bal | 5.00 | 0.15 | 991 | D |
| Example 114 | Bal | 5.00 | 0.50 | 765 | D |
| Example 115 | Bal | 4.50 | 0.01 | 1318 | E |
| Example 116 | Bal | 4.50 | 0.03 | 1305 | E |
| Example 117 | Bal | 4.50 | 0.05 | 1265 | E |
| Example 118 | Bal | 4.50 | 0.15 | 1067 | E |
| Example 119 | Bal | 4.50 | 0.30 | 971 | D |
| Example 120 | Bal | 4.50 | 0.50 | 856 | D |
| Example 121 | Bal | 4.50 | 0.80 | 714 | C |
| Example 122 | Bal | 4.50 | 1.00 | 598 | C |
| Example 123 | Bal | 4.50 | 1.50 | 523 | C |
| Example 124 | Bal | 4.50 | 2.00 | 479 | B |
| Example 125 | Bal | 4.50 | 2.50 | 431 | B |
| Example 126 | Bal | 4.50 | 20.00 | 322 | B |

Table 10 shows the results for alloys containing In, Sn, and Zn in addition to Ga and Bi. The growth of an oxide could be effectively prevented by incorporating Bi. In addition, the effect can be further enhanced by increasing the content of Bi.

**[Table 10]**

| Ga-In-Sn-Zn | Ga | In | Sn | Zn | Bi | Maximum height (µm) | Rank |
|---|---|---|---|---|---|---|---|
| Comparative Example 19 | Bal | 25.00 | 13.00 | 1.00 | 0.00 | 1748 | F |
| Example 127 | Bal | 25.00 | 13.00 | 1.00 | 0.01 | 1127 | E |
| Example 128 | Bal | 25.00 | 13.00 | 1.00 | 0.03 | 1056 | E |
| Example 129 | Bal | 25.00 | 13.00 | 1.00 | 0.05 | 1023 | E |
| Example 130 | Bal | 25.00 | 13.00 | 1.00 | 0.15 | 874 | D |
| Example 131 | Bal | 25.00 | 13.00 | 1.00 | 0.30 | 678 | C |
| Example 132 | Bal | 25.00 | 13.00 | 1.00 | 0.50 | 529 | C |
| Example 133 | Bal | 25.00 | 13.00 | 1.00 | 0.80 | 329 | B |
| Example 134 | Bal | 25.00 | 13.00 | 1.00 | 1.00 | 243 | A |
| Example 135 | Bal | 25.00 | 13.00 | 1.00 | 1.50 | 195 | A |
| Example 136 | Bal | 25.00 | 13.00 | 1.00 | 2.00 | 177 | A |
| Example 137 | Bal | 25.00 | 13.00 | 1.00 | 2.50 | 154 | A |
| Example 138 | Bal | 25.00 | 13.00 | 1.00 | 20.00 | 147 | A |

Tables 11 to 13 show the results for alloys containing Sn and Zn and other additive elements in addition to Ga and Bi. The growth of an oxide could be effectively prevented by incorporating Bi. In addition, the effect can be further enhanced by increasing the content of Bi.

**[Table 11]**

| Additive elements in Ga-Sn-Zn | Ga | Sn | Zn | Sb | Cu | Fe | Al | As | Bi | Maximum height (µm) | Rank |
|---|---|---|---|---|---|---|---|---|---|---|---|
| Example 139 | Bal | 11.00 | 3.00 | 0.10 | | | | | 0.05 | 1246 | E |
| Example 140 | Bal | 11.00 | 3.00 | 0.10 | | | | | 0.50 | 787 | D |
| Example 141 | Bal | 11.00 | 3.00 | 0.05 | | | | | 0.05 | 1284 | E |
| Example 142 | Bal | 11.00 | 3.00 | 0.05 | | | | | 0.50 | 843 | D |
| Example 143 | Bal | 11.00 | 3.00 | | 0.10 | | | | 0.05 | 1299 | E |
| Example 144 | Bal | 11.00 | 3.00 | | 0.10 | | | | 0.50 | 765 | D |
| Example 145 | Bal | 11.00 | 3.00 | | 0.05 | | | | 0.05 | 1315 | E |
| Example 146 | Bal | 11.00 | 3.00 | | 0.05 | | | | 0.50 | 857 | D |
| Example 147 | Bal | 11.00 | 3.00 | | | 0.10 | | | 0.05 | 1312 | E |
| Example 148 | Bal | 11.00 | 3.00 | | | 0.10 | | | 0.50 | 714 | C |
| Example 149 | Bal | 11.00 | 3.00 | | | 0.05 | | | 0.05 | 1369 | E |
| Example 150 | Bal | 11.00 | 3.00 | | | 0.05 | | | 0.50 | 886 | D |
| Example 151 | Bal | 11.00 | 3.00 | | | | 0.10 | | 0.05 | 1169 | E |
| Example 152 | Bal | 11.00 | 3.00 | | | | 0.10 | | 0.50 | 684 | C |
| Example 153 | Bal | 11.00 | 3.00 | | | | 0.05 | | 0.05 | 1288 | E |
| Example 154 | Bal | 11.00 | 3.00 | | | | 0.05 | | 0.50 | 712 | C |
| Example 155 | Bal | 11.00 | 3.00 | | | | | 0.10 | 0.05 | 1312 | E |
| Example 156 | Bal | 11.00 | 3.00 | | | | | 0.10 | 0.50 | 874 | D |
| Example 157 | Bal | 11.00 | 3.00 | | | | | 0.05 | 0.05 | 1333 | E |
| Example 158 | Bal | 11.00 | 3.00 | | | | | 0.05 | 0.50 | 945 | D |

**[Table 12]**

| Additive elements in Ga-Sn-Zn | Ga | Sn | Zn | Ag | Ni | Au | Ti | Bi | Maximum height (µm) | Rank |
|---|---|---|---|---|---|---|---|---|---|---|
| Example 159 | Bal | 11.00 | 3.00 | 0.10 | | | | 0.05 | 1284 | E |
| Example 160 | Bal | 11.00 | 3.00 | 0.10 | | | | 0.50 | 764 | D |
| Example 161 | Bal | 11.00 | 3.00 | 0.05 | | | | 0.05 | 1311 | E |
| Example 162 | Bal | 11.00 | 3.00 | 0.05 | | | | 0.50 | 884 | D |
| Example 163 | Bal | 11.00 | 3.00 | | 0.10 | | | 0.05 | 1254 | E |
| Example 164 | Bal | 11.00 | 3.00 | | 0.10 | | | 0.50 | 681 | C |
| Example 165 | Bal | 11.00 | 3.00 | | 0.05 | | | 0.05 | 1286 | E |
| Example 166 | Bal | 11.00 | 3.00 | | 0.05 | | | 0.50 | 742 | C |
| Example 167 | Bal | 11.00 | 3.00 | | | 0.10 | | 0.05 | 1231 | E |
| Example 168 | Bal | 11.00 | 3.00 | | | 0.10 | | 0.50 | 693 | C |
| Example 169 | Bal | 11.00 | 3.00 | | | 0.05 | | 0.05 | 1268 | E |
| Example 170 | Bal | 11.00 | 3.00 | | | 0.05 | | 0.50 | 722 | C |
| Example 171 | Bal | 11.00 | 3.00 | | | | 0.10 | 0.05 | 1247 | E |
| Example 172 | Bal | 11.00 | 3.00 | | | | 0.10 | 0.50 | 741 | C |
| Example 173 | Bal | 11.00 | 3.00 | | | | 0.05 | 0.05 | 1278 | E |
| Example 174 | Bal | 11.00 | 3.00 | | | | 0.05 | 0.50 | 824 | D |

**[Table 13]**

| Additive elements in Ga-Sn-Zn | Ga | Sn | Zn | Cr | La | Mg | Mn | Bi | Maximum height (µm) | Rank |
|---|---|---|---|---|---|---|---|---|---|---|
| Example 175 | Bal | 11.00 | 3.00 | 0.10 | | | | 0.05 | 1326 | E |
| Example 176 | Bal | 11.00 | 3.00 | 0.10 | | | | 0.50 | 883 | D |
| Example 177 | Bal | 11.00 | 3.00 | 0.05 | | | | 0.05 | 1396 | E |
| Example 178 | Bal | 11.00 | 3.00 | 0.05 | | | | 0.50 | 914 | D |
| Example 179 | Bal | 11.00 | 3.00 | | 0.10 | | | 0.05 | 1303 | E |
| Example 180 | Bal | 11.00 | 3.00 | | 0.10 | | | 0.50 | 864 | D |
| Example 181 | Bal | 11.00 | 3.00 | | 0.05 | | | 0.05 | 1321 | E |
| Example 182 | Bal | 11.00 | 3.00 | | 0.05 | | | 0.50 | 969 | D |
| Example 183 | Bal | 11.00 | 3.00 | | | 0.10 | | 0.05 | 1316 | E |
| Example 184 | Bal | 11.00 | 3.00 | | | 0.10 | | 0.50 | 834 | D |
| Example 185 | Bal | 11.00 | 3.00 | | | 0.05 | | 0.05 | 1326 | E |
| Example 186 | Bal | 11.00 | 3.00 | | | 0.05 | | 0.50 | 978 | D |
| Example 187 | Bal | 11.00 | 3.00 | | | | 0.10 | 0.05 | 1334 | E |
| Example 188 | Bal | 11.00 | 3.00 | | | | 0.10 | 0.50 | 881 | D |
| Example 189 | Bal | 11.00 | 3.00 | | | | 0.05 | 0.05 | 1358 | E |
| Example 190 | Bal | 11.00 | 3.00 | | | | 0.05 | 0.50 | 983 | D |

Tables 14 to 17 show the results for alloys containing In and other additive elements in addition to Ga and Bi. The growth of an oxide could be effectively prevented by incorporating Bi. In addition, the effect can be further enhanced by increasing the content of Bi.

**[Table 14]**

| Additive elements in Ga-In | Ga | In | Sb | Cu | Fe | Al | Bi | Maximum height (µm) | Rank |
|---|---|---|---|---|---|---|---|---|---|
| Comparative Example 20 | Bal | 24.50 | 0.10 | | | | 0.00 | 1601 | F |
| Example 191 | Bal | 24.50 | 0.10 | | | | 0.05 | 742 | C |
| Example 192 | Bal | 24.50 | 0.10 | | | | 0.50 | 187 | A |
| Comparative Example 21 | Bal | 24.50 | 0.05 | | | | 0.00 | 1637 | F |
| Example 193 | Bal | 24.50 | 0.05 | | | | 0.05 | 768 | D |
| Example 194 | Bal | 24.50 | 0.05 | | | | 0.50 | 193 | A |
| Comparative Example 22 | Bal | 24.50 | | 0.10 | | | 0.00 | 1587 | F |
| Example 195 | Bal | 24.50 | | 0.10 | | | 0.05 | 759 | D |
| Example 196 | Bal | 24.50 | | 0.10 | | | 0.50 | 184 | A |
| Comparative Example 23 | Bal | 24.50 | | 0.05 | | | 0.00 | 1632 | F |
| Example 197 | Bal | 24.50 | | 0.05 | | | 0.05 | 754 | D |
| Example 198 | Bal | 24.50 | | 0.05 | | | 0.50 | 199 | A |
| Comparative Example 24 | Bal | 24.50 | | | 0.10 | | 0.00 | 1598 | F |
| Example 199 | Bal | 24.50 | | | 0.10 | | 0.05 | 751 | D |
| Example 200 | Bal | 24.50 | | | 0.10 | | 0.50 | 201 | A |
| Comparative Example 25 | Bal | 24.50 | | | 0.05 | | 0.00 | 1621 | F |
| Example 201 | Bal | 24.50 | | | 0.05 | | 0.05 | 762 | D |
| Example 202 | Bal | 24.50 | | | 0.05 | | 0.50 | 203 | A |
| Comparative Example 26 | Bal | 24.50 | | | | 0.10 | 0.00 | 1576 | F |
| Example 203 | Bal | 24.50 | | | | 0.10 | 0.05 | 769 | D |
| Example 204 | Bal | 24.50 | | | | 0.10 | 0.50 | 196 | A |

**[Table 15]**

| Additive elements in Ga-In | Ga | In | Al | As | Ag | Ni | Bi | Maximum height (µm) | Rank |
|---|---|---|---|---|---|---|---|---|---|
| Comparative Example 27 | Bal | 24.50 | 0.05 | | | | 0.00 | 1589 | F |
| Example 205 | Bal | 24.50 | 0.05 | | | | 0.05 | 772 | D |
| Example 206 | Bal | 24.50 | 0.05 | | | | 0.50 | 203 | A |
| Comparative Example 28 | Bal | 24.50 | | 0.10 | | | 0.00 | 1599 | F |
| Example 207 | Bal | 24.50 | | 0.10 | | | 0.05 | 736 | C |
| Example 208 | Bal | 24.50 | | 0.10 | | | 0.50 | 189 | A |
| Comparative Example 29 | Bal | 24.50 | | 0.05 | | | 0.00 | 1614 | F |
| Example 209 | Bal | 24.50 | | 0.05 | | | 0.05 | 743 | C |
| Example 210 | Bal | 24.50 | | 0.05 | | | 0.50 | 197 | A |
| Comparative Example 30 | Bal | 24.50 | | | 0.10 | | 0.00 | 1597 | F |
| Example 211 | Bal | 24.50 | | | 0.10 | | 0.05 | 747 | C |
| Example 212 | Bal | 24.50 | | | 0.10 | | 0.50 | 181 | A |
| Comparative Example 31 | Bal | 24.50 | | | 0.05 | | 0.00 | 1602 | F |
| Example 213 | Bal | 24.50 | | | 0.05 | | 0.05 | 759 | D |
| Example 214 | Bal | 24.50 | | | 0.05 | | 0.50 | 199 | A |
| Comparative Example 32 | Bal | 24.50 | | | | 0.10 | 0.00 | 1584 | F |
| Example 215 | Bal | 24.50 | | | | 0.10 | 0.05 | 753 | D |
| Example 216 | Bal | 24.50 | | | | 0.10 | 0.50 | 201 | A |
| Comparative Example 33 | Bal | 24.50 | | | | 0.05 | 0.00 | 1611 | F |
| Example 217 | Bal | 24.50 | | | | 0.05 | 0.05 | 774 | D |
| Example 218 | Bal | 24.50 | | | | 0.05 | 0.50 | 205 | A |

**[Table 16]**

| Additive elements in Ga-In | Ga | In | Au | Ti | Cr | La | Bi | Maximum height (µm) | Rank |
|---|---|---|---|---|---|---|---|---|---|
| Comparative Example 34 | Bal | 24.50 | 0.10 | | | | 0.00 | 1603 | F |
| Example 219 | Bal | 24.50 | 0.10 | | | | 0.05 | 725 | C |
| Example 220 | Bal | 24.50 | 0.10 | | | | 0.50 | 191 | A |
| Comparative Example 35 | Bal | 24.50 | 0.05 | | | | 0.00 | 1624 | F |
| Example 221 | Bal | 24.50 | 0.05 | | | | 0.05 | 733 | C |
| Example 222 | Bal | 24.50 | 0.05 | | | | 0.50 | 204 | A |
| Comparative Example 36 | Bal | 24.50 | | 0.10 | | | 0.00 | 1575 | F |
| Example 223 | Bal | 24.50 | | 0.10 | | | 0.05 | 717 | C |
| Example 224 | Bal | 24.50 | | 0.10 | | | 0.50 | 194 | A |
| Comparative Example 37 | Bal | 24.50 | | 0.05 | | | 0.00 | 1589 | F |
| Example 225 | Bal | 24.50 | | 0.05 | | | 0.05 | 746 | C |
| Example 226 | Bal | 24.50 | | 0.05 | | | 0.50 | 206 | A |
| Comparative Example 38 | Bal | 24.50 | | | 0.10 | | 0.00 | 1599 | F |
| Example 227 | Bal | 24.50 | | | 0.10 | | 0.05 | 768 | D |
| Example 228 | Bal | 24.50 | | | 0.10 | | 0.50 | 174 | A |
| Comparative Example 39 | Bal | 24.50 | | | 0.05 | | 0.00 | 1614 | F |
| Example 229 | Bal | 24.50 | | | 0.05 | | 0.05 | 773 | D |
| Example 230 | Bal | 24.50 | | | 0.05 | | 0.50 | 198 | A |
| Comparative Example 40 | Bal | 24.50 | | | | 0.10 | 0.00 | 1600 | F |
| Example 231 | Bal | 24.50 | | | | 0.10 | 0.05 | 752 | D |
| Example 232 | Bal | 24.50 | | | | 0.10 | 0.50 | 166 | A |

**[Table 17]**

| Additive elements in Ga-In | Ga | In | La | Mg | Mn | Bi | Maximum height (µm) | Rank |
|---|---|---|---|---|---|---|---|---|
| Comparative Example 41 | Bal | 24.50 | 0.05 | | | 0.00 | 1613 | F |
| Example 233 | Bal | 24.50 | 0.05 | | | 0.05 | 767 | D |
| Example 234 | Bal | 24.50 | 0.05 | | | 0.50 | 184 | A |
| Comparative Example 42 | Bal | 24.50 | | 0.10 | | 0.00 | 1601 | F |
| Example 235 | Bal | 24.50 | | 0.10 | | 0.05 | 759 | D |
| Example 236 | Bal | 24.50 | | 0.10 | | 0.50 | 185 | A |
| Comparative Example 43 | Bal | 24.50 | | 0.05 | | 0.00 | 1624 | F |
| Example 237 | Bal | 24.50 | | 0.05 | | 0.05 | 770 | D |
| Example 238 | Bal | 24.50 | | 0.05 | | 0.50 | 201 | A |
| Comparative Example 44 | Bal | 24.50 | | | 0.10 | 0.00 | 1598 | F |
| Example 239 | Bal | 24.50 | | | 0.10 | 0.05 | 751 | D |
| Example 240 | Bal | 24.50 | | | 0.10 | 0.50 | 183 | A |
| Comparative Example 45 | Bal | 24.50 | | | 0.05 | 0.00 | 1622 | F |
| Example 241 | Bal | 24.50 | | | 0.05 | 0.05 | 773 | D |
| Example 242 | Bal | 24.50 | | | 0.05 | 0.50 | 202 | A |

The above description of embodiment, description of examples and the disclosure of the drawings are merely examples for describing the invention defined in the claims, and the invention defined in the claims is not limited by the above description of the embodiment and the disclosure of the drawings.

## Claims

1. A metal comprising Ga and Bi,
wherein the metal includes a liquid metal or a liquid metal and a solid metal at 35°C.

2. The metal according to claim 1 comprising Bi in an amount of 0.01 mass% or more and 30 mass% or less.

3. The metal according to claim 1 or 2 further comprising any one or more of In, Sn, Zn, and Ag.

4. The metal according to claim 1 or 2 further comprising any one or more of Ag, Sb, Cu, Fe, Al, As, Ni, Au, Ti, Cr, La, Mg, Mn, Co, Ge, Cd, Pb, P, S, and Si.

5. The metal according to claim 1 or 2 comprising Ga in an amount of 30 mass% or more and 99.99 mass% or less, and Bi in an amount of 0.01 mass% or more and 30 mass% or less.

6. The metal according to claim 1 or 2,
wherein a remainder other than Ga and Bi is any one or more of In, Sn, Zn, and Ag.

7. The metal according to claim 1 or 2,
wherein a remainder other than Ga and Bi is any one or more of In, Sn, Zn, and Ag, and any one or more of In, Sn, Zn, and Ag, and any one or more of Sb, Cu, Fe, Al, As, Ni, Au, Ti, Cr, La, Mg, Mn, Co, Ge, Cd, Pb, P, S, and Si.

8. The metal according to claim 1 or 2 used as a heat dissipation material.

9. An electronic device,
wherein the metal according to claim 1 or 2 is used as a heat dissipation material.
